# EUROPEAN PATENT SPECIFICATION

(11) **EP 1 911 324 B1**
(45) Date of publication and mention of the grant of the patent: **02.05.2018**
(21) Application number: 05818545.5
(22) Date of filing: 14.12.2005
(51) Int. Cl.: H04R 3/04, H04R 29/00, H03G 1/00

(54) **METHOD OF CORRECTION OF ACOUSTIC PARAMETERS OF ELECTRO-ACOUSTIC TRANSDUCERS AND DEVICE FOR ITS REALIZATION**
VERFAHREN ZUR KORREKTUR AKUSTISCHER PARAMETER ELEKTROAKUSTISCHER WANDLER UND EINRICHTUNG ZU SEINER REALISIERUNG
PROCEDE ET DISPOSITIF PERMETTANT DE CORRIGER LES PARAMETRES ACOUSTIQUES DE TRANSDUCTEURS ELECTROACOUSTIQUES

(30) Priority: 18.05.2005 LV 050060
(43) Date of publication of application: 16.04.2008
(73) Proprietor: Real Sound Lab, SIA, Riga LV - 1050 (LV)
(72) Inventor: SKURULS, Raimonds, LV-4650 Jaunvilani (LV)
(74) Representative: Fortuna, Aleksandra
(86) International application number: PCT/LV2005/000014
(87) International publication number: WO 2006/123923

(56) References cited:
- EP-A- 0 624 947
- US-A- 4 628 530
- US-A- 5 761 295
- US-B1- 6 760 451

## Description

This invention relates to the field of acoustics, in particular to methods and devices of correction of acoustic parameters of electro-acoustic transducers and can be applied for improvement of playback parameters of acoustic signals of various electro-acoustic transducers.

There are known devices and methods for correction of acoustic parameters of electro-acoustic transducer by using measurements of acoustic parameters of electro-acoustic transducers where correction is performed both automatically and with participation of sound operator. Disadvantage of the known technical solutions is relatively low precision of measuring and poor quality of correction results.

It is known that human ear perceives information about sound timbre from direct sound, namely, the sound coming directly from acoustic transducer and early reverberation of the sound that reaches listener in first 30ms after direct sound but ignores other sound reverberation. Up to now used measuring devices do not differentiate and separate direct sound waves and early reverberation of sound waves from posterior reverberation of sound waves.

Wherewith, the known technical solutions for correction of acoustic parameters of electro-acoustic transducer that are based on evaluation results of sound pressure caused by electro-acoustic transducer do not reflect real problems of playback of electro-acoustic transducer. Also, changing the evaluation place of sound pressure caused by electro-acoustic transducer, sound pressure frequency responses highly vary in every place making the operator face insoluble problem - which of acquired sound pressure frequency responses to be used and which of parameters additionally to be corrected manually or to be processed differently. Because there is no specified algorithm for obtaining correction, this process starts to resemble art. Using these measuring results for correction of acoustic parameters of electro-acoustic transducer, new sound distortions are created because there is attempt to correct the interference expression of sound waves in certain place of the room in known technical solutions. Thus, that kind of correction of acoustic parameters of electro-acoustic transducer is incorrect and inadequate to the transmission distortions and irregularities of electro-acoustic transducer.

There is known method of measuring the parameters of loudspeaker (USA patent 4,209,672, 24.06.1980., "Method and apparatus for measuring characteristics of a loudspeaker", IPC² H04R 29/00), according to which the measuring result of a perceived sound parameters is transformed from analogue form to a digital form, the acquired result is being exposed to the Fourier Transform, afterwards modified into absolute value, logarithmed and further filtered in order to eliminate the effect of interference and thus to increase the accuracy of loudspeaker parameters' measurements. Finally, the acquired result is being transformed into analogue form and written in memory accordingly, hereto the acquired result is being written repeatedly by back playing the test signal from the generator in certain time interval. Disadvantage of the given method lies in the fact that for adjustment there are being used measurements that do not reflect the sound distortions of the electro-acoustic system and filtration process does not differentiate sound distortions created by the electro-acoustic system from the ones created by the room. Thus, the calculated adjustment is inaccurate and the result of adjustment creates worse sound than before its making.

There is known an acoustic signal correction device (USA patent 5,581,621, 03.12.0996., "Automatic adjustment system and automatic adjustment method for audio devices", IPC⁶ H03G 5/00) that contains memory device for equalizer data keeping, audio device with programmable equalizer that selectively modifies audio signal accordingly to the equalizer data, the audio signal analyzer that generates bench signal which keeps in its memory pattern profile of the preferable frequency response that the audible sound output signal is being compared to. Hereto, the signal analyzer is connected to programmable equalizer and audio device but audio device generates audible sound signal accordingly to bench signal. Besides, the acoustic signal correction device contains tools for automatic equalizer data correction accordingly to collation results. Memory device keeps in memory frequency response pattern profile and adjustment results. Equalizer also contains tools that divide output signal into many frequencies' sub ranges. Disadvantage of the given range lies in the fact that for the correction of acoustic signals there are being used measurements that do not reflect the sound distortions of electro-acoustic system, wherewith adjustments create worse sound than before their making.

There are also known other methods of correction of acoustic parameters of electro-acoustic transducers and devices for their implementation, for instance, US6760451 discloses compensating filters, US4628530 discloses automatic equalizing system with DFT and FFT,US5761295 discloses a telephone instrument and method for altering audible characteristics.

There is also known an acoustic characteristic correction device (EP 0624947, 27.08.2003., "Acoustic characteristic correction device", IPC⁷ H03G 5/16) where known device consists of:
- Measuring block that includes Measuring Section consisting of: Signal Source with test signals written in memory, amplifier, playback device, measuring device, amplifier of tested signal, registrar that fixes received signals from the mentioned measuring device as well as includes processing part for determination of correction parameters;
- And Correction block that includes Control Section with correction parameters written in memory and Realization Block for entering the required parameters. Optimal parameters for concrete needs are supplied by making correction in zones, dividing frequency range in zones, hereto, one end of the zone covers beginning of others. Disadvantage of the known device lies in its limited functional options, insufficient measurements precision of electro-acoustic transducer and relatively bad sound of corrected playback signal. The relatively bad sound of corrected playback signal is connected to the fact, that the correction characteristics are defined inaccurately, because, firstly, for correction of acoustical signals there are used measurements that do not display real problems of sound quality perceived by the listener. Secondly, adequate correction parameters are evaluated subjectively by participation of operator that causes doubts about the objectivity of correction, and, thirdly, the known technical solution intends dividing frequency range into relatively broad zones that decrease number of samples on the frequency's axis, thus loosing information about characteristics changes of frequency response on the frequency axis.

The goal of invention is to increase playback quality of acoustic signal of various electro-acoustic transducers, to increase precision and speed of corrections of acoustic parameter of electro-acoustic transducer related to it, as well as to increase the validity of automatic correction with minimal participation of the operator.

The set target is being achieved with correction method of acoustic parameters of electro-acoustic transducer that contains measuring of the acoustic parameters of electro-acoustic transducer in the ambient space of the electro-acoustic transducer or its segment, acquiring the measurement results from many discreet points of this surface or segment, processing of the acquired measurement results, calculation of acoustic power frequency response of electro-acoustic transducer according to the processing measurement results of the acoustic parameters of electro-acoustic transducer, determining the correction parameters of electro-acoustic transducer with the help of acoustic power frequency response of electro-acoustic transducer and acoustic signal correction.

The set target can also be achieved by:
- Evaluation of acoustic power frequency response of electro-acoustic transducer is being acquired by moving the measuring device consecutively from one discreet point of the electro-acoustic transducer's ambient space to another, making measurements with the interval of 0,2 ÷ 3,2 seconds and by using test signal whose duration is within boundaries of 0,05 ÷ 3,2 s;
- In the site of evaluations of acoustic power frequency response of electro-acoustic transducer where one lower horizontal reflective surface is dominating, electro-acoustic transducer's acoustic parameters are being measured on the segment of electro-acoustic transducer's ambient space, one side of which collides with the lower horizontal reflective surface, hereto the measurements' surface is perpendicular the direction to the electro-acoustic transducer which parameters are measured;

- In order to acquire evaluation of acoustic power frequency response of electro-acoustic transducer in the site where there are several dominating surfaces, measurements are being made along the lines that connect candidly chosen point on the lower horizontal acoustic environment's reflective surface with candidly chosen point on every other acoustic environment's reflective surface;
- In order to acquire the evaluation of acoustic power frequency response of electro-acoustic transducer in the site where surfaces have complicated configuration, measurements are being made along imaginary circle line, which is placed in a vertical plane, athwart the direction to the electro-acoustic transducer and along horizontal diameter and vertical diameter of this imaginary circle line;
- In order to acquire the evaluation of acoustic power frequency response of electro-acoustic transducer in small rooms with parallel walls, measurements in the room are made cornerwise from its symmetry centre to the corners that are farthest from the electro-acoustic transducer.
- Impulse responseresponse of each particular discrete measurement is processed by Window Function, hereto the width of Window Function is chosen in amplitude of 0,04 ÷0,12 s;
- Evaluation of acoustic power frequency response of electro-acoustic transducer is equalized in logarithmic frequency scale; hereto evaluation of acoustic power frequency response is equalized by equalization function of cosine impulse.

Set goal is achieved also by offering device for realization of correction of acoustic parameters of electro-acoustic transducer (see Claim 11) consisting of
- Measuring System that contains Measuring Section consisting of signal sources with test signals written in memory for generation of mentioned test signals, amplifier of playback signals, measuring devices, amplifier of tested signals, registrar that records received signals from the mentioned measuring device, output of Measuring Section, as well as measurements processing section for determination of correction parameters and Interface Block;
- And corrector that involves Control Section with correction parameters written in memory and Realization Block of correction, hereto the measurements processing section involves: Impulse Response Calculation Block for performing of composition operation between output signal of Measuring System and Spectrum Inversion Function Block for calculation of impulse response, Window Function block that multiplies samples of impulse responsesponse signals with samples of Window Function in order to exclude effect of interfering components, Fast Fourier Transform block that computes Fast Fourier Transform from impulse response signal, defining frequency sample data array on each separate impulse response, synchronization block that synchronizes the beginning of input data of Fast Fourier Transform with highest values of impulse response, registrar that stores data array of frequency samples, Acoustic Power Frequency Response Calculation block that calculates acoustic power frequency response from the mentioned data array of frequency samples, re-sampling block that converts acoustic power frequency response from linear scale to logarithmic scale, display for exposing the calculated acoustic power frequency response, block that defines correction levels of ranges ends of acoustic power frequency response, equalizing block for acoustic power frequency response that serves for eliminating the effects of small irregularities and interferences of acoustic power frequency response, re-sampling block for transformation of power frequency response from logarithmic scale to linear scale, inverter for calculation of inverse value of power frequency response samples, Filtration Block for power frequency response samples that serves for obtaining total impulse response of corrector, inverse Fast Fourier Transform calculation block that calculates samples of impulse response of correction and sends data to normalized samples calculation block of impulse response, hereto the mentioned Realization Block calculates the composition operation between input signal of sound signal and impulse responses of correction from Control Section, and sends the obtained calculation result to Sound Signal Output.

The device, in addition, can contain block for calculation of average value of synchronized impulse responses, a block for calculation of time delay of groups, equalization block of group delay, block for calculation of phase corrector of frequency response from time delay frequency response and a block that adjusts the phase of acoustic power frequency response by multiplying the respective sample of acoustic power frequency response with the respective sample of acoustic power frequency response in complex form. The device can also contain several correctors.

Method of correction of acoustic parameters of electro-acoustic transducer and device for realization of the method is described in attached drawings, where:
In Fig.1A there is described alternative scheme of discrete point disposition of measuring of acoustic parameters of electro-acoustic transducer in the site with one dominating - the lower horizontal reflective surface;
In Fig.IB - alternative scheme of discrete point disposition of measuring of acoustic parameters of electro-acoustic transducer in the site where there are several dominating reflective surfaces;
In Fig.2A - alternative scheme of discrete point disposition of measuring of acoustic parameters of electro-acoustic transducer in relatively small rooms with parallel walls;
In Fig.2B - alternative scheme of discrete point disposition of measuring of acoustic parameters of electro-acoustic transducer in the site where reflective surfaces have complicated configurations;
Fig. 3 - test signal form;
Fig. 4 - overal block diagram of correction device of acoustic parameters of electro-acoustic transducer;
Fig. 5 - detailed block diagram of Measuring Section of Measuring System of acoustic parameters of electro-acoustic transducer correction device;
Fig. 6 - detailed block diagram of Measurements Processing Section of Measuring System of acoustic parameters of electro-acoustic transducer correction device;

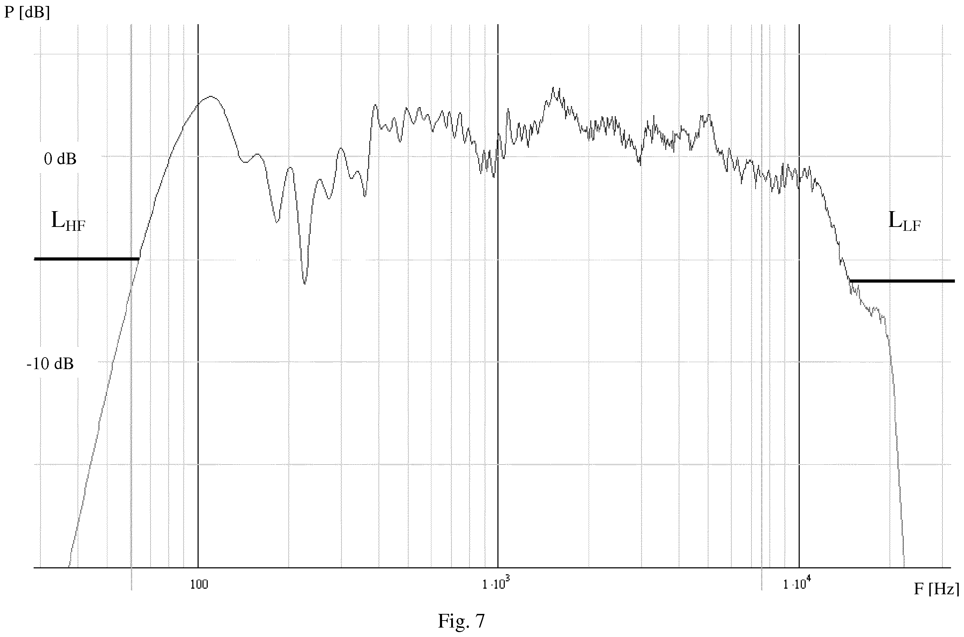

Fig. 7 - acoustic power frequency response with indicated amplifications/decay of the ends;
Fig. 8 - equalized acoustic power frequency response.

### Example of realization of the invention

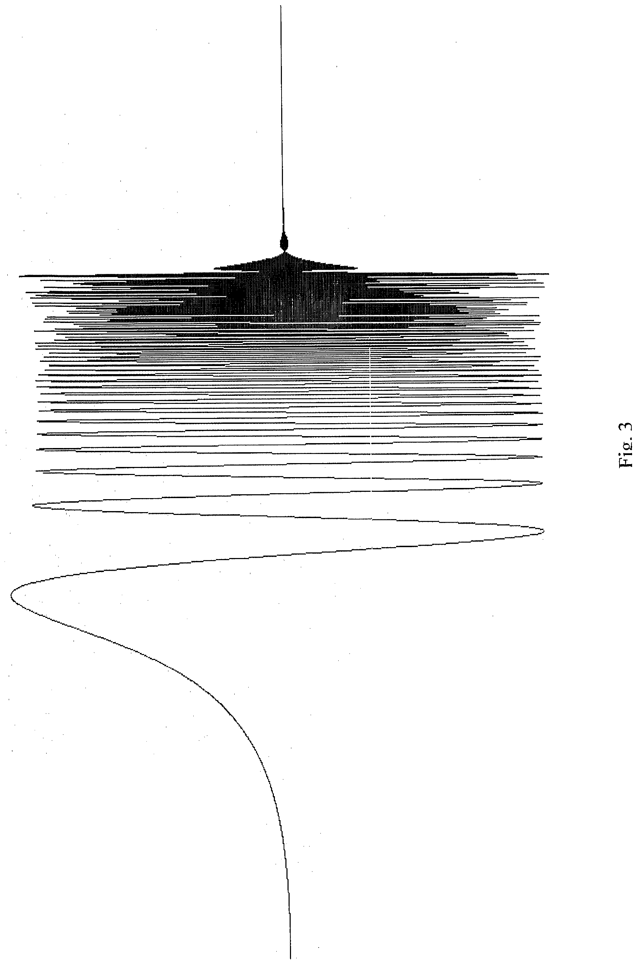

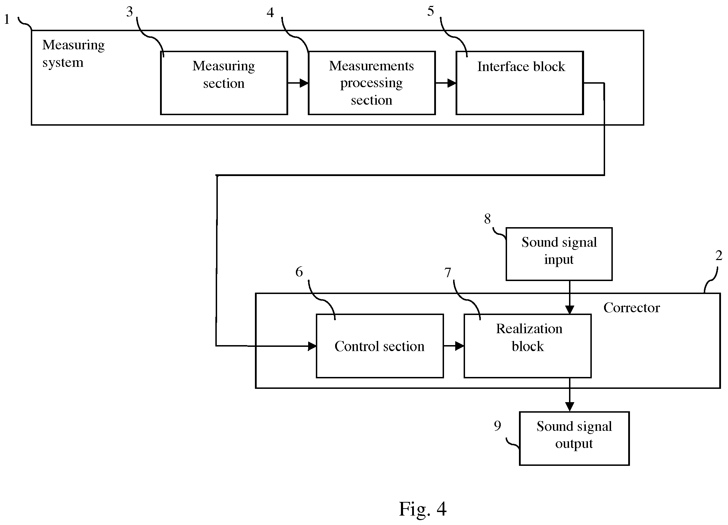

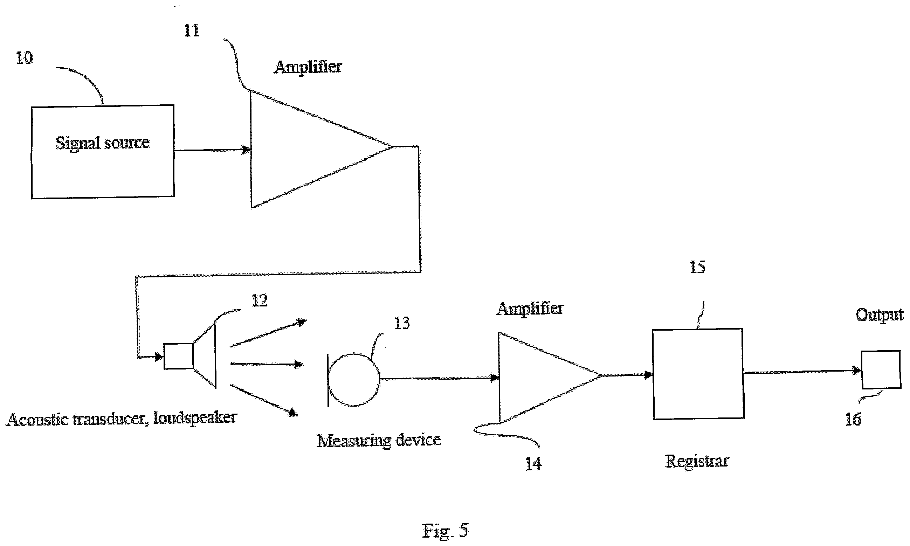

The correction of acoustic parameters of electro-acoustic transducer is being made with the device described in Fig. 4 that consists of Measuring System 1 and at least one corrector 2, where Measuring System consists of Measuring Section 3 and, the measurements processing section 4 and Interface Block 5, but corrector 2 - from Control Section 6, Realization Block 7 with Sound Signal Input 8 and Sound Signal Output 9. The correction of acoustic parameters of electro-acoustic transducer by offered method is being made as follows:
Schematically described Signal Source 10 (Fig. 5) with in memory written acoustic test signals repeatedly plays back test signal whose spectrum is balanced with interference spectrum in the site of measurements. Therefore, test signal is being chosen with higher energy in the lower frequency area of the spectrum, where the interference energy is higher, as well as such that has small enough ratio of the highest value to average value. In this example of realization of the invention such signal is chosen with whom the signal/noise relation in range of 20 ÷ 30 dB can be obtained. The chosen duration of played test signal (Fig. 3) is 0,05 s.

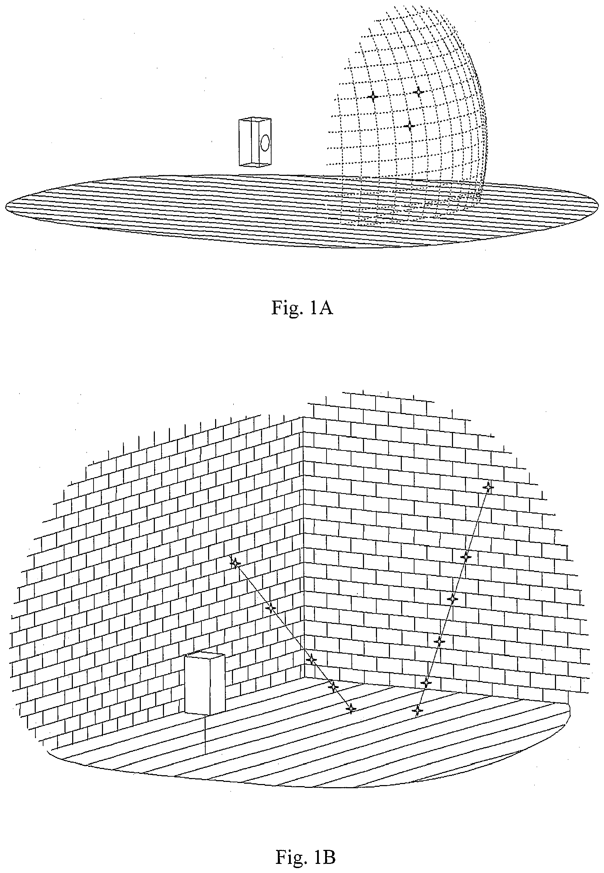

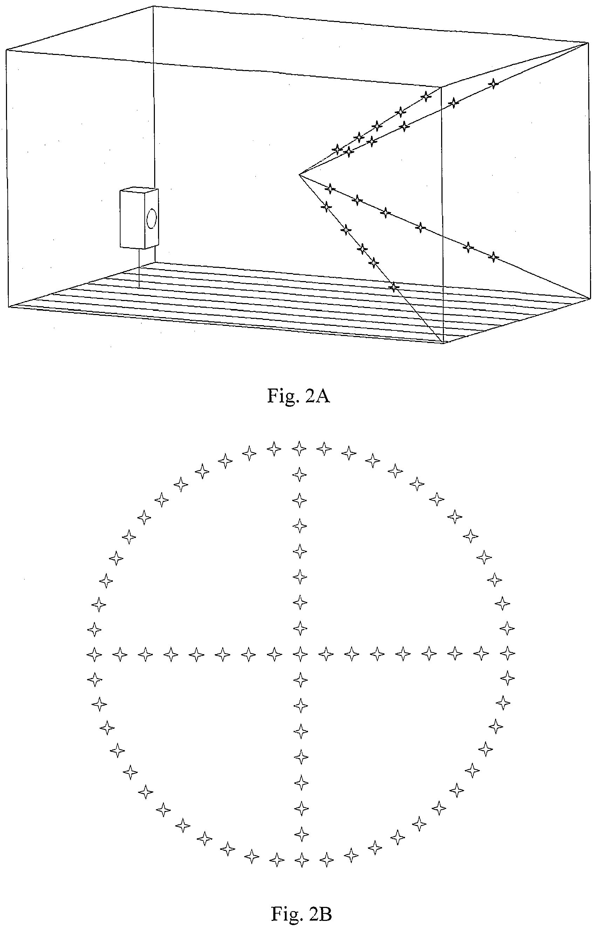

Further, the played acoustic test signal is amplified with amplifier 11 and is played with electro-acoustic transducer 12 that is electro-acoustic transducer which is being corrected. Measuring device 13 receives with 0.4s time interval the played acoustic test signal in discrete points of acoustic environment embraced by electro-acoustic transducers. Hereto, the measurements are taken on segment of ambient space of electro-acoustic transducer by evenly moving measuring device from one measuring point to another, like it is shown schematically in Fig.1A. Taking measurements of parameters of electro-acoustic transducer in the rooms where there are several asymmetrically placed dominating reflective surfaces, the measuring device is being moved along lines that connect point on the floor with the point on dominating reflective surface of each room, as it is shown in Fig.IB. Taking measurements of parameters of electro-acoustic transducer in the rooms with parallel walls, the measuring device is being moved cornerwise (see Fig. 2A) from symmetry centre to corners of the room that are farthest from electro-acoustic transducer. Taking measurements of parameters of electro-acoustic transducer in the rooms where reflective surfaces have complex configuration or where taking of measurements is complicated by objects existent in the room, the measuring device is being moved like it is shown in Fig.2B - along imaginary circle line, which is placed in a vertical plane, athwart the direction to the electro-acoustic transducer and along horizontal diameter and vertical diameter of this imaginary circle line.

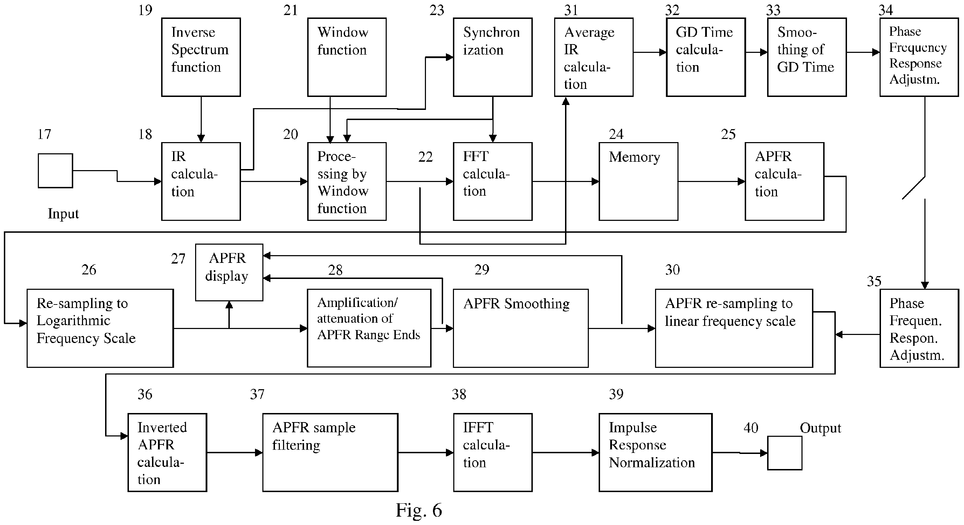

Further, acoustic test signal perceived by Measuring Device 13 through Amplifier 14 comes in Registrar 15 where all signals obtained in measuring points are entered and through Output 16 are entered in Input 17 of Measurement Processing Section 4 for calculation of parameters of Correction Filter (Fig.6). Further, signal is entered in the Impulse response Calculation Block 18 for performing composition operation between signal of output 4 of Measuring Section and Spectrum Inversion Function stored in the Spectrum Inversion block 19, for calculation of impulse response in order to calculate impulse responses of electro-acoustic transducer in the measuring points. Further, signal is entered in Window Function block 20 in order to exclude such distortion factors as effects of non-linear and reverberation. Window Function block 20 multiplies samples of impulse response signals with samples of Window Function stored in memory of block 21.

Window Function is being utilized so that at the impulse response highest values' Window Function is 1 but at the lowest impulse response values the Window Function is leaning towards 0 thus excluding interference factors from the measurements, such as non-linearity and reverberation. With Window Function that is longer in time, higher distinction of measurements in the area of low frequency is possible while as a result, the effect of reverberation increases. But with Window Function that is shorter in time, the impact of room decreases although information about the lower frequency area starts to disappear.

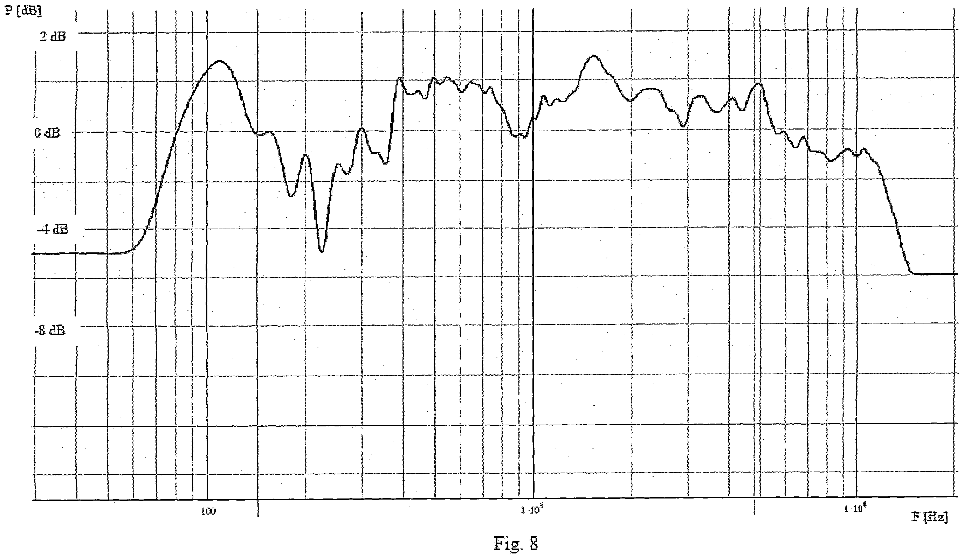

After the processing of signal in Window Function block 20 the acquired results are being entered in Fast Fourier Transform block 22 that calculates Fast Fourier Transform from the impulse response signal determining frequency sample array for each separate impulse response, in synchronization block 23 that coordinates the beginning of Fast Fourier Transform input array with highest value of impulse response. The acquired data is then being entered in the Registrar 24 that stores frequency sample array, the acoustic power frequency response is being calculated in block 25 that calculates acoustic power frequency response from the mentioned frequency sample array and in Re-sampling Block 26 that transforms acoustic power frequency response from linear frequency scale into logarithmic frequency scale. The calculated acoustic power frequency response is being displayed in Display 27. Afterwards, the calculation results are being entered in block 28 that determines the correction levels (see Fig. 8) of acoustic power frequency response's range ends. Correction levels of range ends in the lower frequency area (L_{LF}) and in the high frequency area (L_{HF}) are being chosen depending on correctable electro-acoustic transducer's ability to play back lower and high frequency signals without overload. In this example of realization of the invention, the correction levels of range ends are being chosen in the area -5 dB of lower frequency and area -6 dB of high frequency area.

Further the calculation results are being entered in Acoustic Power Frequency Response Leveling Block 29 that serves for elimination of the effect of small irregularities and interference of the acoustic power frequency response (see Fig. 8) and in Re-sampling Block 30 for transforming of power frequency response from logarithmic scale into linear scale. Besides, before the Fast Fourier Transform Block 22 the acquired results additionally are being entered in block 31 that calculates the average value of synchronized impulse response, sends it to block 32 for calculation of Group Delay Time, to the Group Delay Leveling Block 33, block 34 that calculates Phase Frequency Response of corrector 2 from group delay time frequency response, and block 35 that corrects acoustic power frequency response phase by multiplying the respective acoustic power frequency response sample with the respective phase frequency response sample in complex form and then sends to Inverter 36 for calculation of inverted value of acoustic power frequency response sample. Afterwards, the acquired results are being sent to power Frequency Response Sample Filtration Block 37 that serves for acquiring of total impulse response of corrector 2, afterwards are being sent to Inverse Fast Fourier Transform calculation block 38 that calculates impulse response samples of corrector 2 and sends data to Impulse response Normalized Sample Calculation Block 39 and to Output 40 of the Measurements Processing Section 4. The acquired data array further is being sent to Interface Block 5 that saves the impulse response sample array received from the processing section and afterwards is being sent to corrector 2 Control Section 6 for saving of different correction impulse responses. From Control Section 6 acquired results go into Realization Block 7 that calculates composition operation between the signal of Sound Signal Input 8 and the correction impulse response received from the Control Section 6. Further the correction result is being channeled to Sound Signal Output 9, wherefrom it is being sent to the amplifier and the respective electro-acoustic transducer for playback.

Constant transmission coefficient between input signal of corrector and reflected acoustic power of electro-acoustic transducer on different working frequencies is reached by making corrections of electro-acoustic transducer with the offered method and device. Besides, undistorted power of sound Signal Source transmission to acoustic power is provided and deep correction of timbre distortions of electro-acoustic transducer does not make new sound defects, and as a result, working in different conditions and different places, timbraly distortion-free, natural sound is gained.

## Claims

1. A method of correction of acoustic parameters of electro-acoustic transducer including: measuring of acoustic parameters of an electro-acoustic transducer, processing the measuring results, calculating correction parameters for the electro-acoustic transducer, correcting an acoustic signal based on calculated correction parameters for the electro-acoustic transducer, wherein said calculating correction parameters of electro-acoustic transducer is performed by using an acoustic power frequency response of the electro-acoustic transducer, by taking measurements in the ambient space of the electro-acoustic transducer wherein said measurements are obtained from many discreet points in said space.

2. The method according to claim 1, wherein obtaining the evaluation of acoustic power frequency response of electro-acoustic transducer by moving measuring device from one discreet point in the ambient space of the electro-acoustic transducer to another, taking measurements with the interval of 0,2 ÷ 3,2 seconds and by using test signal which duration is within boundaries of 0,05 ÷ 3,2 seconds.

3. The method according to claims 1 or 2, wherein for decreasing of reverberation effect caused by acoustic environment's reflective surfaces, impulse response of each particular discreet measurement is processed by Window function.

4. The method according to claim 3, wherein the width of Window function is chosen in amplitude of 0,04 ÷0,12 s.

5. The method according to any preceding claims, wherein the evaluation of acoustic power frequency response of the electro-acoustic transducer is equalized in scale of logarithm frequency.

6. The method according to claim 5, wherein the evaluation of acoustic power frequency response of the electro-acoustic transducer is equalized by equalization function of cosine impulse.

7. A correction device system of acoustic parameters of electro-acoustic transducer for realization of a correction method, the correction device system consisting of a measuring system and at least one corrector, the measuring system further comprising a measuring section, a measurement processing section and an interface block, the measuring section consisting of signal source with test signals written in memory for generation of mentioned test signals, amplifier of playback signal, measurement device, amplifier of measured signals, registrar that records signals received from the mentioned measuring device, output of measuring section to the measurement processing section for determination of correction parameters, the mentioned corrector comprising a control section with in memory written correction parameters, realization block for correction realization, wherein the Measurements Processing Section (4) contains:
- Impulse response calculation block (18) for performing composition operation between output signal of Measuring Section (4) and in spectrum inversion block (19) stored spectrum inversion function for calculation of impulse response;
- Window function block (20), that multiplies samples of impulse response signals with samples of Window function stored in block (21) memory in order to exclude the effect of interference components;
- Fast Fourier Transform block (22) that calculates Fast Fourier Transform from the impulse response signal determining frequency sample array for each separate impulse response;
- Synchronization block (23) that coordinates the beginning of Fast Fourier Transform input array with highest value of impulse response;
- Registrar (24) that stores frequency samples array;
- Acoustic Power Frequency Response Calculation Block (25) that calculates acoustic power frequency response from the mentioned frequency sample arrays;
- Re-sampling Block (26) that transforms acoustic power frequency response from linear frequency scale into logarithmic frequency scale;
- Display (27) for displaying of calculated acoustic power frequency response;
- Block (28) that determines the correction levels of acoustic power frequency response's range ends;
- Acoustic Power Frequency Response Leveling Block (29) that serves for elimination of the effects of small irregularities and interferences of acoustic power frequency response;
- Re-sampling Block (30) for transforming of power frequency response from logarithmic scale into linear scale;
- Inverter (36) for calculation of invert values of power frequency response sample;
- Power Frequency Response Sample Filtering Block (37) that serves for acquiring of total impulse response of Corrector (2);
- Inverse Fast Fourier Transform Calculation Block (38) that calculates impulse response samples of Corrector (2) and sends data to
- Impulse response Normalized Sample Calculation Block (39) adapted to generate correction impulses reaction corresponding to said correction parameters written in the control section, and
- Output block (40) adapted to output said correction impulses reaction, hereto Realization Block (7) calculates composition operation between the signal of a Sound Signal Input (8) and said correction impulse response from Control Section (6) and sends the calculation result to Sound Signal Output (9).

8. The correction device system according to claim 7, wherein it further comprises:
- Block (31) that calculates average value of synchronized impulse response;
- Block (32) for calculation of group time delay;
- Group Time Delay Equalization Block (33);
- Block (34) that calculates corrector phase frequency response from group time delay frequency response and
- Block (35) that corrects phase of acoustic power frequency response by multiplying respective sample of acoustic power frequency response with the respective phase frequency response sample in complex form.

## Patentansprüche

1. Verfahren zur Korrektur akustischer Parameter eines elektroakustischen Wandlers, umfassend: Messen von akustischen Parametern eines elektroakustischen Wandlers, Verarbeiten der Messergebnisse, Berechnen von Korrekturparametern für den elektroakustischen Wandler, Korrigieren eines akustischen Signals auf der Grundlage berechneter Korrekturparameter für den elektroakustischen Wandler, wobei das Berechnen von Korrekturparametern eines elektroakustischen Wandlers durchgeführt wird, indem eine akustische Netzfrequenzkennlinie des elektroakustischen Wandlers verwendet wird, Messungen in der Umgebung des elektroakustischen Wandlers durchgeführt und die Messergebnisse von vielen diskreten Punkten in dieser Umgebung empfangen werden.

2. Verfahren nach Anspruch 1, wobei die Bewertung der akustischen Netzfrequenzkennlinie des elektroakustischen Wandlers durch Bewegen der Messvorrichtung von einem diskreten Punkt in der Umgebung des elektroakustischen Wandlers zu einem anderen empfangen wird und Messungen mit einem Intervall von 2 ÷ 3,2 Sekunden durchgeführt werden, wobei ein Testsignal, dessen Dauer innerhalb des Grenzwertes von 0,05 ÷ 3,2 Sekunden liegt, verwendet wird.

3. Verfahren nach Anspruch 1 oder 2, wobei zum Verringern des Nachhalleffekts, der durch die reflektierenden Oberflächen der akustischen Umgebung verursacht wird, die Impulsantwort jeder einzelnen diskreten Messung durch die Fensterfunktion verarbeitet wird.

4. Verfahren nach Anspruch 3, wobei die Breite der Fensterfunktion aus einer Amplitude von 0,04 ÷ 0,12 s gewählt wird.

5. Verfahren nach einem der vorhergehenden Ansprüche, bei dem die Bewertung der akustischen Netzfrequenzkennlinie des elektroakustischen Wandlers im Maßstab der Logarithmusfrequenz kompensiert wird.

6. Verfahren nach Anspruch 5, wobei die Bewertung der Netzfrequenzkennlinie des elektroakustischen Wandlers durch die Ausgleichsfunktion des Kosinusimpulses kompensiert wird.

7. Korrekturgerätesystem für akustische Parameter eines elektroakustischen Wandlers zur Durchführung eines Korrekturverfahrens, wobei das Korrekturgerätesystem aus folgenden Elementen besteht: einem Messsystem und mindestens einem Korrektor, wobei das Messsystem weiterhin einen Messabschnitt, einen Messverarbeitungsabschnitt und einen Schnittstellenblock umfasst, und die Messstrecke aus einer Signalquelle mit in den Speicher geschriebenen Testsignalen zur Erzeugung der erwähnten Testsignale besteh; ferner einem Verstärker des Wiedergabesignals, einer Messvorrichtung, einem Verstärker für die gemessenen Signale, einer Registriervorrichtung, die die von der erwähnten Messvorrichtung empfangenen Signale aufzeichnet, einem Ausgang des Messabschnitts zum Messverarbeitungsabschnitt, um die Korrekturparameter zu bestimmen, wobei der erwähnte Korrektor ein Programmsegment mit in den Speicher geschriebenen Korrekturparametern und einen Realisierungsblock zur Korrekturrealisierung umfasst und der Messungsverarbeitungsabschnitt (4) Folgendes enthält:
- Impulsantwort-Berechnungsblock (18) zum Ausführen einer Zusammensetzungsoperation zwischen dem Ausgangssignal des Messabschnitts (4) und der im Spektruminversionsblock (19) gespeicherten Spektrumsinversionsfunktion zur Berechnung der Impulsantwort;
- Fensterfunktionsblock (20), der Abtastwerte von Impulsantwortsignalen mit den in Block (21) gespeicherten Abtastwerten der Fensterfunktion multipliziert, um den Effekt von Interferenzkomponenten auszuschließen;
- Fast-Fourier-Transformationsblock (22), der eine schnelle Fourier-Transformation aus dem von Impulsantwortsignalen festgelegten Frequenzabtastfeld für jede getrennte Impulsantwort berechnet;
- Synchronisationsblock (23), der den Anfang des Fast-Fourier-Transformations-Eingangsarrays mit dem höchsten Wert der Impulsantwort koordiniert;
- Registriervorrichtung (24), die das Frequenzabtastfeld speichert;
- Berechnungsblock für die akustische Netzfrequenzkennlinie (25), der die akustische Netzfrequenzkennlinie aus den erwähnten Frequenzabtastfeldern berechnet;
- Neuabtastblock (26), der die akustische Netzfrequenzkennlinie aus der linearen Frequenzskala in die logarithmische Frequenzskala überträgt.
- Anzeige (27) zum Anzeigen der berechneten akustischen Netzfrequenzkennlinie;
- Block (28), der die Korrekturpegel der Bereichsenden der akustischen Netzfrequenzkennlinie festlegt;
- Nivellierungsblock für die akustische Netzfrequenzkennlinie (29), der dazu dient, die Auswirkungen von kleinen Unregelmäßigkeiten und Interferenzen der akustischen Netzfrequenzkennlinie zu beseitigen;
- Neuabtastblock (30), der die Netzfrequenzkennlinie aus der logarithmischen Skala in die lineare Skala überträgt;
- Inverter (36) zur Berechnung von Invertierungswerten der Netzfrequenzkennlinienabtastung;
- Filterblock (37) für die abgetastete Netzfrequenzkennlinie, der zum Erfassen der Gesamtimpulsantwort des Korrektors (2) dient;
- Berechnungsblock für die schnelle Invers-Fouriertransformation (38), der Impulsantwort-Abtastwerte des Korrektors (2) berechnet und Daten
- zum normalisierten Impulsantwort-Abtastberechnungsblock (39) sendet, der angepasst ist, um eine Korrekturimpulsreaktion zu erzeugen, die den in das Programmsegment geschriebenen Korrekturparametern entspricht; und
- Ausgabeblock (40) zur Ausgabe der Korrekturimpulsreaktion,
Hierzu berechnet der Realisierungsblock (7) die Zusammensetzungsoperation zwischen dem Signal eines Schallsignaleingangs (8) und der Korrekturimpulsantwort des Programmsegments (6) und sendet das Berechnungsergebnis an den Schallsignalausgang (9).

8. Elektronisches Korrekturgerätesystem gemäß Anspruch 7, ferner umfassend:
- Block (31), der den Durchschnittswert der synchronisierten Impulsantwort berechnet;
- Block (32) für die Berechnung der Gruppenzeitverzögerung;
- Ausgleichsblock (33) für die Gruppenzeitverzögerung;
- Block (34), der den Korrektorphasenfrequenzganz aus der Gruppenzeitverzögerung des Frequenzgangs berechnet und
- Block (35), der die Phase der akustischen Netzfrequenzkennlinie korrigiert, indem er die jeweilige Abtastung der akustischen Netzfrequenzkennlinie mit der jeweiligen Abtastung des Phasenfrequenzgangs in komplexer Form multipliziert.

## Revendications

1. Procédé de correction de paramètres acoustiques de transducteur électroacoustique, incluant : la mesure de paramètres acoustiques d'un transducteur électroacoustique, le traitement des résultats de mesure, le calcul de paramètres de correction pour le transducteur électroacoustique, la correction d'un signal acoustique sur la base des paramètres de correction calculés pour le transducteur électroacoustique, dans lequel ledit calcul de paramètres de correction de transducteur électroacoustique est effectué en utilisant une réponse en fréquence de puissance acoustique du transducteur électroacoustique, en prenant des mesures dans l'espace ambiant du transducteur électroacoustique dans lequel lesdites mesures sont obtenues à partir de nombreux points discrets dans ledit espace.

2. Procédé selon la revendication 1, dans lequel l'obtention de l'évaluation de réponse en fréquence de puissance acoustique du transducteur électroacoustique en déplaçant le dispositif de mesure d'un point discret dans l'espace ambiant du transducteur électroacoustique jusqu'à un autre, en prenant des mesures avec l'intervalle de 0,2 ÷ 3,2 secondes et en utilisant un signal de test dont la durée est dans les limites de 0,05 ÷ 3,2 secondes.

3. Procédé selon la revendication 1 ou 2, dans lequel, pour une diminution d'un effet de réverbération causé par les surfaces réfléchissantes de l'environnement acoustique, une réponse d'impulsion de chaque mesure discrète particulière est traitée par une fonction de fenêtre.

4. Procédé selon la revendication 3, dans lequel la largeur de la fonction de fenêtre est choisie dans une amplitude de 0,04 ÷ 0,12 s.

5. Procédé selon l'une quelconque des revendications précédentes, dans lequel l'évaluation de réponse en fréquence de puissance acoustique du transducteur électroacoustique est égalisée en échelle de fréquence logarithmique.

6. Procédé selon la revendication 5, dans lequel l'évaluation de réponse en fréquence de puissance acoustique du transducteur électroacoustique est égalisée par une fonction d'égalisation d'impulsion cosinusoïdale.

7. Système de dispositif de correction de paramètres acoustiques d'un transducteur électroacoustique pour la réalisation d'un procédé de correction, le système de dispositif de correction étant constitué d'un système de mesure et d'au moins un correcteur, le système de mesure comprenant en outre une section de mesure, une section de traitement de mesure et un bloc d'interface, la section de mesure étant constituée d'une source de signal avec des signaux de test écrits en mémoire pour la génération de signaux de test mentionnés, un amplificateur de signal de lecture, un dispositif de mesure, un amplificateur de signaux mesurés, un enregistreur qui enregistre des signaux reçus du dispositif de mesure mentionné, une sortie de la section de mesure vers la section de traitement de mesure pour la détermination de paramètres de correction, le correcteur mentionné comprenant une section de commande avec en mémoire des paramètres de correction écrits, un bloc de réalisation pour la réalisation de correction, dans lequel la section de traitement de mesures (4) contient :
- un bloc de calcul de réponse d'impulsion (18) pour l'exécution d'une opération de composition entre le signal de sortie de la section de mesure (4) et dans un bloc d'inversion de spectre (19) une fonction d'inversion de spectre stockée pour le calcul de la réponse d'impulsion ;
- un bloc de fonction de fenêtre (20), qui multiplie les échantillons de signaux de réponse d'impulsion avec des échantillons de fonction de fenêtre stockés dans la mémoire du bloc (21) afin d'exclure l'effet de composantes d'interférence ;
- un bloc de transformation de Fourier rapide (22) qui calcule une transformation de Fourier rapide à partir du signal de réponse d'impulsion déterminant une matrice d'échantillons de fréquence pour chaque réponse d'impulsion indépendante ;
- un bloc de synchronisation (23) qui coordonne le début de la matrice d'entrée de transformation de Fourier rapide avec la valeur la plus élevée de réponse d'impulsion ;
- un enregistreur (24) qui stocke la matrice d'échantillons de fréquence ;
- un bloc de calcul de réponse en fréquence de puissance acoustique (25) qui calcule la réponse en fréquence de puissance acoustique à partir des matrices d'échantillons de fréquence mentionnées ;
- un bloc de ré-échantillonnage (26) qui transforme la réponse en fréquence de puissance acoustique d'une échelle de fréquence linéaire en une échelle de fréquence logarithmique ;
- un affichage (27) pour l'affichage de la réponse en fréquence de puissance acoustique calculée ;
- un bloc (28) qui détermine les niveaux de correction des extrémités de plage de réponse en fréquence de puissance acoustique ;
- un bloc de lissage de réponse en fréquence de puissance acoustique (29) qui sert à l'élimination des effets de petites irrégularités et interférences de réponse en fréquence de puissance acoustique ;
- un bloc de ré-échantillonnage (30) pour transformer la réponse en fréquence de puissance d'une échelle logarithmique en échelle linéaire ;
- un inverseur (36) pour le calcul de valeurs inverses d'échantillon de réponse en fréquence de puissance ;
- un bloc de filtrage d'échantillon de réponse en fréquence de puissance (37) qui sert à l'acquisition d'une réponse d'impulsion totale du correcteur (2) ;
- un bloc de calcul de transformation de Fourier rapide inverse (38) qui calcule les échantillons de réponse d'impulsion du correcteur (2) et envoie les données à
- un bloc de calcul d'échantillon normalisé de réponse d'impulsion (39) conçu pour générer une réaction d'impulsions de correction correspondant auxdits paramètres de correction écrits dans la section de commande, et
- un bloc de sortie (40) conçu pour délivrer en sortie ladite réaction d'impulsions de correction,
à ce sujet, un bloc de réalisation (7) calcule une opération de composition entre le signal d'une entrée de signal sonore (8) et ladite réponse d'impulsion de correction provenant de la section de commande (6) et envoie le résultat de calcul à une sortie de signal sonore (9).

8. Système de dispositif de correction selon la revendication 7, où il comprend en outre :
- un bloc (31) qui calcule une valeur moyenne de réponse d'impulsion synchronisée ;
- un bloc (32) pour le calcul d'un délai de temporisation de groupe ;
- un bloc d'égalisation de délai de temporisation de groupe (33) ;
- un bloc (34) qui calcule une réponse de fréquence de phase de correcteur à partir de la réponse de délai de temporisation de groupe et
- un bloc (35) qui corrige la phase de réponse en fréquence de puissance acoustique en multipliant l'échantillon respectif de réponse en fréquence de puissance acoustique avec l'échantillon de réponse de fréquence de phase respectif sous forme complexe.
